# EUROPEAN PATENT APPLICATION

(11) **EP 4 567 962 A2**
(43) Date of publication of application: **11.06.2025**
(21) Application number: 24216541.3
(22) Date of filing: 29.11.2024
(51) Int. Cl.: H01M 10/48, H01M 50/507, H01M 50/519, H01M 50/569

(54) **BATTERY MODULE**

(30) Priority: 05.12.2023 KR 20230174885
(71) Applicant: SAMSUNG SDI CO., LTD., Yongin-si, Gyeonggi-do 17084 (KR)
(72) Inventor: Park, Kyunghoon, 17084 Yongin-si, Gyeonggi-do (KR)
(74) Representative: Gulde & Partner

(57) **Abstract**

A battery module includes a bus bar configured to electrically connect a plurality of battery cells to each other, a holder bus bar configured to fix the bus bar, and a voltage measurement circuit portion configured to measure a voltage of each of the plurality of battery cells, and the voltage measurement circuit portion is integrally formed with the holder bus bar.

## Description

### BACKGROUND

### 1. Field

Aspects of embodiments of the present disclosure relate to a battery module.

### 2. Description of the Related Art

Secondary batteries are rechargeable, unlike non-rechargeable primary batteries. Low-capacity secondary batteries may be used in small portable electronic devices, such as smartphones, feature phones, laptop computers, digital cameras, and camcorders, and high-capacity secondary batteries may be used as motor-driving power sources, power-storing batteries, etc. for hybrid vehicles, electric vehicles, etc. A secondary battery may include an electrode assembly including a cathode and an anode, a case accommodating the electrode assembly, an electrode terminal connected to the electrode assembly, etc.

A battery module includes a plurality of battery cells. The battery module is configured to measure a voltage to identify a state of charge of each of the plurality of battery cells. Examples of an electronic component that measures a voltage of each battery cell may include a wire harness, a flexible printed circuit assembly (FPCA), etc. In the related art, the wire harness has been used as the electronic component. However, with an increasing number of battery cells in a battery module, it has become difficult to use a structure employing a wire harness due to an excessively large volume of the structure. The FPCA is available as an alternative to the wire harness. However, due to a complicated manufacturing process of the FPCA in comparison to that of the wire harness, a manufacturing cost of the FPCA is high.

The above-described information disclosed in the background of the present disclosure is provided for improving the understanding of the background of the present disclosure, and, thus, may include information that does not constitute the related art.

### SUMMARY

According to an aspect of one or more embodiments of the present disclosure, a battery module including a coupling structure of a circuit measuring a voltage of a battery cell and a holder bus bar is provided. According to another aspect of one or more embodiments of the present disclosure, a battery module with reduced manufacturing costs due to improving a formation structure of an electronic component that measures the voltage of battery cells included in the battery module is provided.

However, aspects and technical problems to be solved by the present disclosure are not limited to those mentioned herein, and other aspects and problems to be solved may be clearly understood by those of ordinary skill in the art from the description of the present disclosure described below.

Additional aspects will be set forth, in part, in the description which follows and, in part, will be apparent from the description, or may be learned by practice of the presented embodiments of the present disclosure.

According to one or more embodiments of the present disclosure, a battery module includes a bus bar configured to electrically connect a plurality of battery cells to each other, a holder bus bar configured to fix the bus bar, and a voltage measurement circuit portion configured to measure a voltage of each of the plurality of battery cells.

The voltage measurement circuit portion is integrally formed with the holder bus bar.

The voltage measurement circuit portion may be formed on a surface of the holder bus bar by laser direct structuring (LDS).

The battery module may further include an insulating film covering the voltage measurement circuit portion.

The insulating film may include a polyimide (PI) resin or a polyethylene naphthalate (PEN) resin.

The voltage measurement circuit portion and the bus bar may be electrically connected to each other through a wire bonding structure.

The voltage measurement circuit portion and the bus bar may be electrically connected to each other through a flexible printed circuit (FPC) component.

The voltage measurement circuit portion and the bus bar may be electrically connected to each other through a flexible die cut (FDC) component.

The voltage measurement circuit portion and the bus bar may be electrically connected to each other through a lug terminal.

A component electrically connecting the voltage measurement circuit portion to the bus bar may include a fuse portion configured as a FPC.

A component electrically connecting the voltage measurement circuit portion to the bus bar may include a fuse portion having a hybrid structure of a FDC and a FPC.

### BRIEF DESCRIPTION OF THE DRAWINGS

The above and other aspects, features, and advantages of certain embodiments of the present disclosure will be more apparent from the following description taken in conjunction with the accompanying drawings.

The following drawings attached to this specification illustrate some example embodiments of the present disclosure, and are intended to provide a further understanding of the technical idea of the present disclosure together with the detailed description of the present disclosure described below; however, the present disclosure is not to be construed as being limited to the matters shown in the drawings.
FIG. 1 is a perspective view showing an assembly structure of a bus bar, a holder bus bar, and a voltage measurement circuit portion included in a battery module according to an embodiment of the present disclosure;
FIG. 2 is a perspective view showing some components shown in FIG. 1 being separated;
FIG. 3 is a cross-sectional view taken along the line III-III shown in FIG. 1;
FIG. 4 is an enlarged view of a region "A" shown in FIG. 3;
FIG. 5 is a perspective view showing an assembly structure of a bus bar, a holder bus bar, and a voltage measurement circuit portion included in a battery module according to another embodiment of the present disclosure;
FIG. 6 is a perspective view showing some components shown in FIG. 5 being separated; and
FIG. 7 is a view showing a configuration in which a fuse portion is formed in a component that electrically connects the voltage measurement circuit portion to the bus bar shown in FIG. 5.
FIG. 8 is a perspective view showing an example shape of lug terminal.

### DETAILED DESCRIPTION

Reference will now be made in further detail to some embodiments, examples of which are illustrated in the accompanying drawings, wherein like reference numerals refer to like elements throughout. In this regard, the present embodiments may have different forms and are not to be construed as being limited to the descriptions set forth herein. Accordingly, the embodiments are described below, by referring to the figures, to explain aspects of the present description. As used herein, the term "and/or" includes any and all combinations of one or more of the associated listed items. Expressions such as "at least one of," if preceding a list of elements, modify the entire list of elements and do not modify the individual elements of the list.

Herein, some embodiments of the present disclosure will be described in further detail with reference to the accompanying drawings. The terms and words used in the present specification and claims should not be construed as being limited to ordinary or dictionary meanings, and are to be interpreted as having meanings and concepts consistent with the technical idea of the present disclosure based on the principle that the present inventors may appropriately define the concept of the terms to describe their invention in the best way. Therefore, it is to be understood that the configurations shown in the drawings and embodiments described in this specification are some example embodiments of the present disclosure, and do not necessarily represent all of the technical ideas of the present disclosure, such that there may be various equivalents and variations that replace them at the time of filing the present application. If used herein, "comprise," "include," "comprising," and/or "including" specify mentioned shapes, numbers, steps, operations, members, components, and/or presence of these groups, but do not exclude the presence or addition of one or more different shapes, numbers, operations, members, components, and /or groups. If embodiments of the present disclosure are described, "can" or "may" may include "one or more embodiments of the present disclosure."

To facilitate understanding of the present disclosure, the accompanying drawings may not be shown according to the actual scale, but the dimensions of some components may be exaggerated. The same reference numeral may be given to the same component in different embodiments.

A statement that two comparison targets are "the same" as each other may mean that they are the same or substantially the same as each other. Thus, a case in which the comparison targets are "the same" or "substantially the same" as each other may include a case in which they have a deviation regarded as a low level, e.g., a deviation of 5 % or less. If a uniform parameter is uniform in a predetermined area, it may mean that it is uniform from an average point of view.

Although the terms "first," "second," etc., may be used to describe various components, these components are not limited by these terms. These terms are used to distinguish one component from other components, and, unless specifically stated to the contrary, a first component may be described as a second component.

Throughout the specification, unless specially stated to the contrary, each component may be singular or plural.

If a component is arranged on "a top portion (or a bottom portion)" of another component or "on (or under)" the other component, it may refer to not only a case in which the component is arranged adjacent to a top surface (or a bottom surface) of the other component, but also a case in which another component may be interposed between the other component and the component arranged on (or under) the other component.

If a component is described as being "connected," "coupled," or "connectable" to another component, it is to be understood that the components may be directly connected, coupled, or connectable to each other, but another component may be interposed between the components, or the components may be "connected," "coupled," or "connectable" to each other through another component. Similarly, if a portion is electrically coupled to another portion, this may include not only a case in which they are directly connected to each other, but also a case in which they are connected with another device therebetween.

Throughout the specification, "A and/or B" may mean A, B, or A and B, unless specifically stated otherwise. That is, "and/or" may include all or any combination of a plurality of items listed. "C to D" may mean at least C but not more than D, unless specifically stated otherwise.

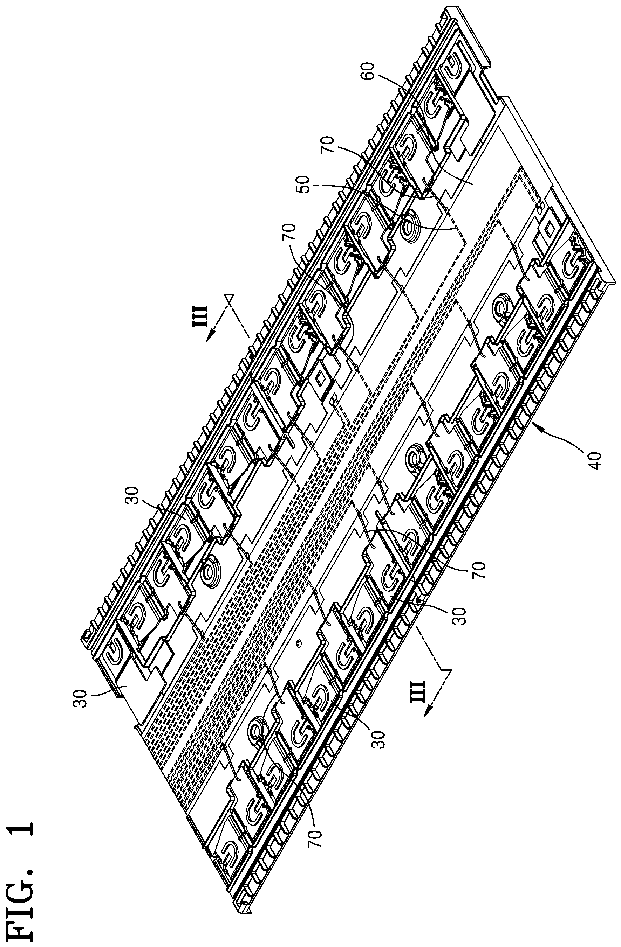

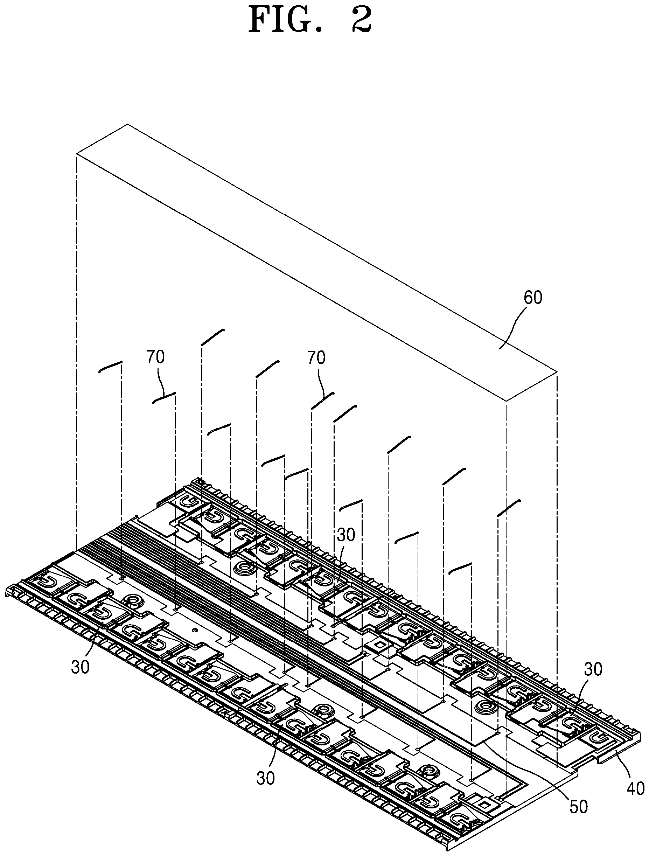

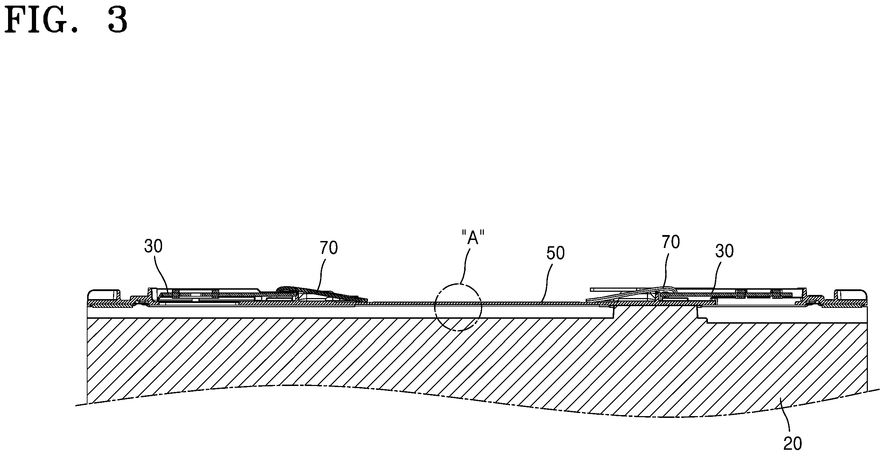

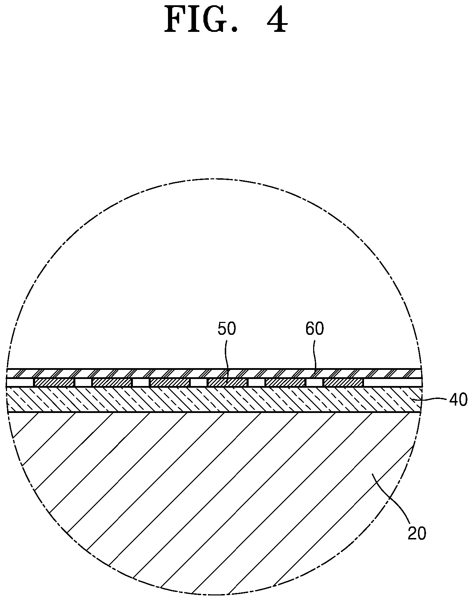

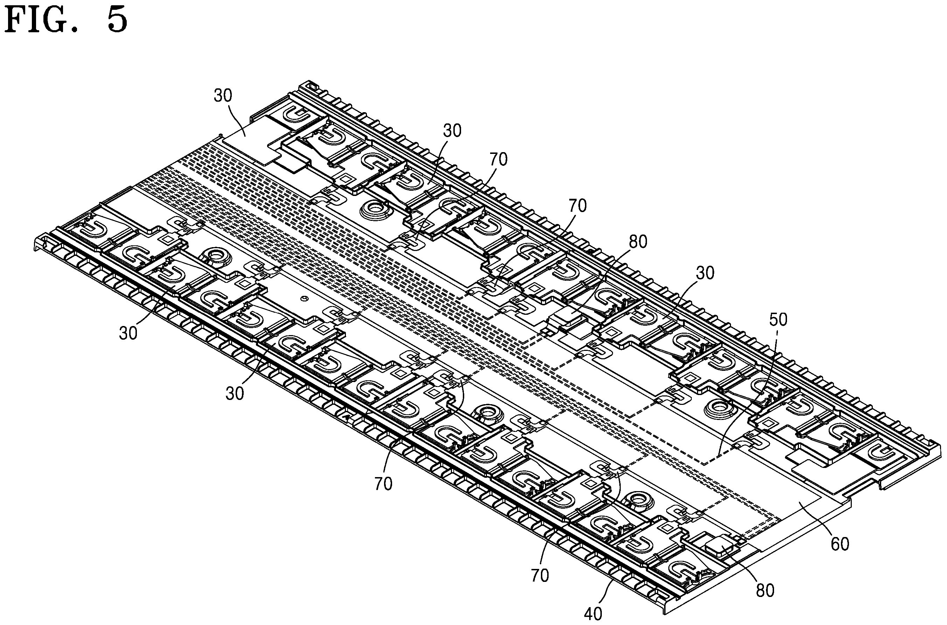

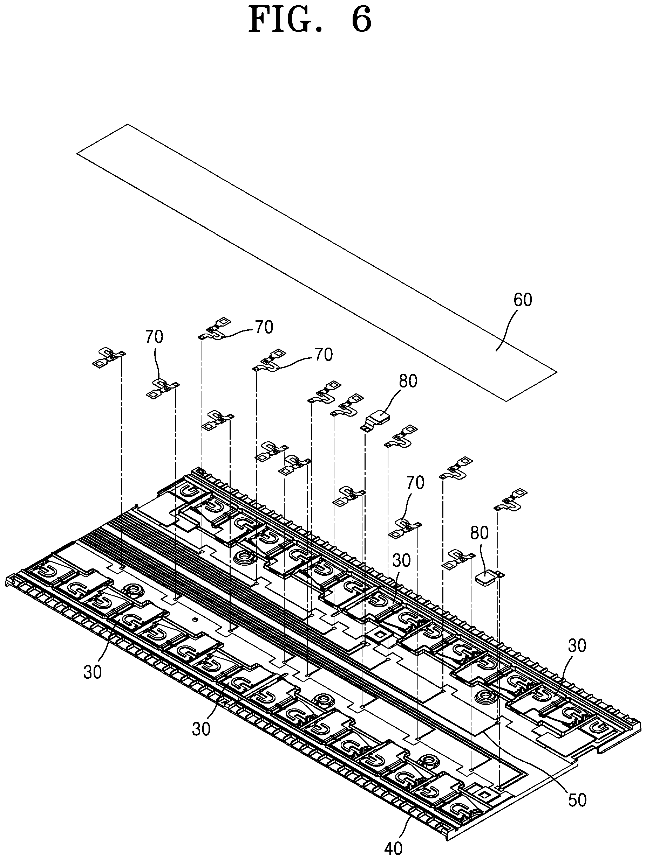

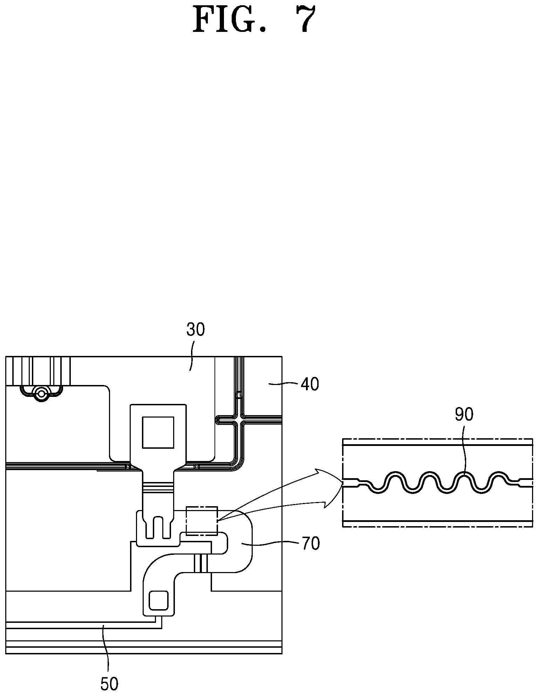

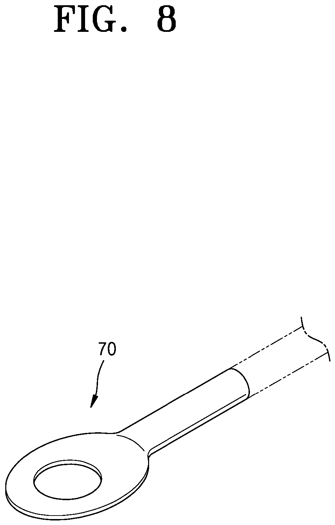

FIG. 1 is a perspective view showing an assembly structure of a bus bar, a holder bus bar, and a voltage measurement circuit portion included in a battery module according to an embodiment of the present disclosure. FIG. 2 is a perspective view showing some components shown in FIG. 1 being separated. FIG. 3 is a cross-sectional view taken along the line III-III shown in FIG. 1. FIG. 4 is an enlarged view of a region "A" shown in FIG. 3. FIG. 5 is a perspective view showing an assembly structure of a bus bar, a holder bus bar, and a voltage measurement circuit portion included in the battery module according to another embodiment of the present disclosure. FIG. 6 is a perspective view showing some components shown in FIG. 5 being separated. FIG. 7 is a view showing a configuration in which a fuse portion is formed in a component that electrically connects the voltage measurement circuit portion to the bus bar shown in FIG. 5. FIG. 8 is a perspective view showing an example shape of lug terminal.

Referring to FIGS. 1 to 8, a battery module according to the present disclosure may include a plurality of battery cells 20. In an embodiment, the battery cell 20 may be a prismatic (e.g., square) battery cell. The plurality of battery cells 20 may be provided. The battery cells 20 may be arranged (e.g., regularly arranged) in a case (not shown).

In an embodiment, the battery module may include a bus bar 30, a holder bus bar 40, a voltage measurement circuit portion 50, an insulating film 60, and a connection component 70.

The bus bar 30 is a component that electrically connects the plurality of battery cells 20 to each other. In an embodiment, the bus bar 30 may include a metal with electrical conductivity.

The holder bus bar 40 is a component that fixes the bus bar 30 in a certain position. In an embodiment, the holder bus bar 40 may include synthetic resin. The bus bar 30 may be coupled in a structure supported by upper and lower supports formed on the holder bus bar 40.

The voltage measurement circuit portion 50 may perform a function of measuring a voltage of the battery cell 20. The voltage measurement circuit portion 50 may be connected to the battery cell 20 through the bus bar 30. The voltage measurement circuit portion 50 may be integrally formed with the holder bus bar 40. The voltage measurement circuit portion 50 may be inseparably coupled to the holder bus bar 40.

The voltage measurement circuit portion 50 may be formed on a surface of the holder bus bar 40. The voltage measurement circuit portion 50 may be formed on an upper surface of the holder bus bar 40. For example, the voltage measurement circuit portion 50 may be formed by using a laser direct structuring (LDS) method. In an embodiment, LDS may be implemented by surface-treating a part constituting the voltage measurement circuit portion 50 by irradiating laser light and then plating the same with copper (Cu) and nickel (Ni) to configure an electric circuit. The voltage measurement circuit portion 50 may be formed before the holder bus bar 40 and the bus bar 30 are coupled to each other.

The insulating film 60 is a structure that covers the voltage measurement circuit portion 50. The insulating film 60 may electrically protect the voltage measurement circuit portion 50. In an embodiment, the insulating film 60 may include an insulating synthetic resin. For example, the insulating film 60 may include a polyimide (PI) resin or polyethylene naphthalate (PEN) resin. The insulating film 60 may be attached to the voltage measurement circuit portion 50 using, for example, a thermal compression or adhesive method.

Referring to FIGS. 1 to 3, the voltage measurement circuit portion 50 and the bus bar 30 may be electrically connected to each other through a connection component 70 of a wire bonding structure.

Referring to FIGS. 5 to 7, the voltage measurement circuit portion 50 and the bus bar 30 may be electrically connected to each other through the connection component 70 including a flexible printed circuit (FPC) component. Although the FPC component has a relatively high manufacturing cost, it has an advantage of configuring a precise fuse portion 90. In this case, the connection component 70 may be configured in a structure in which, for example, a nickel tab and an FPC are coupled to each other.

The voltage measurement circuit portion 50 and the bus bar 30 may be electrically connected to each other through the connection component 70 including a flexible die cut (FDC) circuit component. In an embodiment, the FDC component may be formed by cutting a conductive metal thin plate into a pattern (e.g., a predetermined pattern) by using upper and lower rollers and then adhering the same to a resin film. The FDC component may have an advantage of low manufacturing cost. In this case, the connection component 70 may be configured in a structure in which, for example, a nickel tab and an FPC are coupled to each other.

In an embodiment, the voltage measurement circuit portion 50 and the bus bar 30 may be electrically connected to each other through a lug terminal as the connection component 70. The lug terminal may have an advantage of being easily adopted as a connection component of a known structure that may be conventionally used.

The connection component 70 that electrically connects the voltage measurement circuit portion 50 to the bus bar 30 may include a fuse portion 90 configured as the FPC. The fuse portion 90 may electrically protect the voltage measurement circuit portion 50 if overcurrent flows from the battery cell 20. In an embodiment, the FPC may have an advantage of precisely forming a structure of the fuse portion 90 with a width of 0.08 mm or less.

In an embodiment, the connection component 70 that electrically connects the voltage measurement circuit portion 50 to the bus bar 30 may include the fuse portion 90 in a hybrid structure as a mixture of a FDC and a FPC. The FDC may be produced at low cost, but may be limited in manufacturing a width of a circuit pattern formed to be smaller than a certain size. Although the FPC may be expensive to manufacture, it may be advantageous to manufacturing the precise fuse portion 90 because a width of a circuit pattern formed may be formed much smaller than that of the FDC. Thus, a hybrid component in which most of circuits are manufactured with the FDC and the precise fuse portion 90 (e.g., only the precise fuse portion 90) is manufactured with the FPC and coupled to each other using a method such as hot pressing may provide the effects of maintaining stable quality and reducing manufacturing costs.

In an embodiment, the voltage measurement circuit portion 50 may include a temperature sensor 80. In an embodiment, the FDC/FPC hybrid structure may also be adopted in a component that connects the temperature sensor 80 to the voltage measurement circuit portion 50. The temperature sensor 80 is a sensor that measures the temperature of the battery cell 20.

As described above, in the battery module according to one or more embodiments of the present disclosure, a voltage measurement circuit portion that measures the voltage of a battery cell is integrally formed with a holder bus bar, and, thus, manufacturing costs may be reduced and an assembly process may be simplified, thereby providing an effect of innovatively improving productivity. The voltage measurement circuit portion and the bus bar may be connected to each other in various forms. If a component that electrically connects the voltage measurement circuit portion to the bus bar is formed in a hybrid structure of a FDC and a FPC, as in one or more embodiments of the present disclosure, manufacturing costs may be reduced by applying the FDC, and a precise safety device may effectively configure the fuse portion 90 by applying the FPC.

As described above, in one or more embodiments of the battery module according to the present disclosure, the voltage measurement circuit portion that measures the voltage of a battery cell is integrally formed with the holder bus bar, and, thus, there is no need to assemble the voltage measurement circuit portion and the holder bus bar through a separate process, thereby providing an effect of significantly reducing cost.

Further, if the voltage measurement circuit portion is formed on the holder bus bar using an LDS method, as in one or more embodiments of the present disclosure, the quality and durability of the voltage measurement circuit portion may be improved.

Further, if the component that connects the voltage measurement circuit portion to the bus bar includes the FPC and the FDC, as in one or more embodiments of the present disclosure, a cost of configuring a fuse portion that prevents or substantially prevents the voltage measurement circuit portion from being damaged by overcurrent may be reduced.

However, aspects and effects that may be obtained through the present disclosure are not limited to the above-described aspects and effects, and other technical aspects and effects not mentioned may be clearly understood by those of ordinary skill in the art from the description of the present disclosure described herein.

While the present disclosure has been described by some example embodiments and drawings, the present disclosure is not limited thereby, and various modifications and changes may be made by those of ordinary skill in the art within the equivalent ranges to the claims set forth below.

In the battery module according to one or more embodiments of the present disclosure, a voltage measurement circuit portion that measures the voltage of a battery cell is integrally formed with a holder bus bar, and, thus, there is no need to assemble the voltage measurement circuit portion and the holder bus bar through a separate process, thereby providing the effect of significantly reducing a cost.

It is to be understood that the embodiments described herein are to be considered in a descriptive sense and not for purposes of limitation. Descriptions of features or aspects within each embodiment should typically be considered as available for other similar features or aspects in other embodiments. While one or more embodiments have been described with reference to the figures, it is to be understood by those of ordinary skill in the art that various changes in form and details may be made therein without departing from the spirit and scope of the present disclosure as set forth in the following claims.

## Claims

1. A battery module comprising:
a bus bar (30) configured to electrically connect a plurality of battery cells (20) to one another;
a holder bus bar (40) configured to fix the bus bar (30); and
a voltage measurement circuit portion (50) configured to measure a voltage of each of the plurality of battery cells (20),
wherein the voltage measurement circuit portion (50) is integrally formed with the holder bus bar (40).

2. The battery module as claimed in claim 1, wherein the voltage measurement circuit portion (50) is formed on a surface of the holder bus bar (40) by laser direct structuring, LDS.

3. The battery module as claimed in claim 1 or 2, further comprising an insulating film (60) covering the voltage measurement circuit portion (50).

4. The battery module as claimed in claim 3, wherein the insulating film (60) comprises a polyimide, PI, resin or a polyethylene naphthalate, PEN, resin.

5. The battery module as claimed in any of the preceding claims, wherein the voltage measurement circuit portion (50) and the bus bar (30) are configured to be electrically connected to each other through a wire bonding structure.

6. The battery module as claimed in any of claim 1 to 5, wherein the voltage measurement circuit portion (50) and the bus bar (30) are configured to be electrically connected to each other through a flexible printed circuit, FPC, component.

7. The battery module as claimed in any of claims 1 to 5, wherein the voltage measurement circuit portion (50) and the bus bar (30) are configured to be electrically connected to each other through a flexible die cut, FDC, component.

8. The battery module as claimed in any of claims 1 to 5, wherein the voltage measurement circuit portion (50) and the bus bar (30) are configured to be electrically connected to each other through a lug terminal.

9. The battery module as claimed in any of claims 1 to 8, wherein a component electrically connecting the voltage measurement circuit portion (50) to the bus bar (30) comprises a fuse portion (90) configured as a FPC.

10. The battery module as claimed in any of claims 1 to 8, wherein a component electrically connecting the voltage measurement circuit portion (50) to the bus bar (30) comprises a fuse portion (90) having a hybrid structure of a FDC and a FPC.

11. The battery module as claimed in any of claims 1 to 10, wherein the voltage measurement circuit portion (50) include a temperature sensor (80) for measuring a temperature of the battery cell (20).

12. The battery module as claimed in claim 10 and 11, wherein the FDC/FPC hybrid structure is adopted in a component that connects the temperature sensor (809 to the voltage measurement circuit portion (50).
